# EUROPÄISCHE PATENTSCHRIFT

(11) **EP 1 071 981 B1**
(45) Veröffentlichungstag und Bekanntmachung des Hinweises auf die Patenterteilung: **12.03.2003**
(21) Anmeldenummer: 99924681.2
(22) Anmeldetag: 25.03.1999
(51) Int. Cl.: G03F 1/14, G03F 1/16

(54) **VERFAHREN ZUR HERSTELLUNG GROSSFLÄCHIGER MEMBRANMASKEN**
METHOD FOR PRODUCING LARGE-SURFACE MEMBRANE MASKS
PROCEDE DE PRODUCTION DE MASQUES A MEMBRANES DE SURFACE ETENDUE

(30) Priorität: 25.03.1998 DE 19813208
(43) Veröffentlichungstag der Anmeldung: 31.01.2001
(73) Patentinhaber: Institut für Mikroelektronik Stuttgart (Stiftung des Öffentlichen Rechts), 70569 Stuttgart (DE)
(72) Erfinder: BUTSCHKE, Jörg, D-70327 Stuttgart (DE); LETZKUS, Florian, D-72070 Tübingen (DE); PENTEKER, Elisabeth, Beaverton, OR 97006 (US); SPRINGER, Reinhard, D-72172 Sulz (DE); HÖFFLINGER, Bernd, D-71063 Sindelfingen (DE); LÖSCHNER, Hans, Schreygasse 3, A-1020 Wien (AT)
(74) Vertreter: Gahlert, Stefan, Dr.-Ing.
(86) Internationale Anmeldenummer: DE9900905
(87) Internationale Veröffentlichungsnummer: WO99049365

(56) Entgegenhaltungen:
- DE-A- 3 730 642
- DE-A- 3 900 526
- DE-C- 19 710 798

## Beschreibung

Für die Elektronen- und lonen-Projektions-Lithografie sowie Röntgenlithografie müssen Membranmasken mit Dicken im Mikrometerbereich und mit Membranflächen bis zu mehr als 100 Quadratzentimeter Größe hergestellt werden. Die nach dem erfindungsgemäßen Verfahren erzeugten Membranmasken können generell für Lithographieverfahren mit geladenen Teilchen und mit Photonen Anwendung finden. Ein Beispiel ist der Einsatz bei 157 nm Lithographie. Ebenso ist eine Verwendung zur Maskierung gegenüber neutralen Teilchen (Atomlithographie) sowie bei allen Anwendungen mit Aufdampfmaske möglich. Membranmasken als Produkt eines Verfahrens gemäß der vorliegenden Erfindung sind auch generell für Sensoren verwendbar.

Ausgehend von Siliziumscheiben als Substratmaterial werden zur Herstellung der Membranmasken zwei unterschiedliche technologische Prozeßvarianten verfolgt. Sie unterscheiden sich grundsätzlich dadurch, ob die Prozeßschritte zur Maskenstrukturierung vor oder nach der Membranherstellung erfolgen.

Beim sogenannten "Membrane Flow Process", wie er beispielsweise in dem US-Patent 5 110 373 dargestellt ist, wird zuerst die Membran hergestellt und alle Prozeßschritte zur Erzeugung der Maskenstrukturen finden auf der Membran statt. Der Nachteil dieser Prozeßfolge besteht darin, daß die sehr kritischen Schritte der Maskenstrukturierung auf einer relativ instabilen Membran ablaufen.

Beim sogenannten "Wafer Flow Process", wie er beispielsweise in der PCT-Anmeldung WO 97/43694 dargestellt ist, werden zuerst die Maskenstrukturen auf einem kompakten Siliziumwafer erzeugt und die Membranherstellung findet am Ende des Maskenprozesses statt. Der kritische Punkt dieser Prozeßfolge besteht darin, daß während der Membranätzung an den bereits vorhandenen Maskenstrukturen keine bzw. nur reproduzierbare Veränderungen auftreten dürfen.

Gemäß dem US-Patent 5 110 373 und der PCT-Anmeldung WO 97/43694 kommt die herkömmliche elektrochemische Ätzstoptechnik mit einem sogenannten PN-Ätzstop zur Anwendung.

Erschwerend besteht bei allen Prozessen zur Herstellung von Membranmasken das Problem, daß die Membran einerseits eine gewisse Zugspannung aufweisen muß, um sehr stabil eine ebene Fläche zu verkörpern, andererseits diese Zugspannung so klein, wie möglich gehalten werden muß, da sie zwangsweise zu Verzeichnungen der Maskenstrukturen und zu Lebensdauerproblemen führt.

Hier bietet der Wafer Flow Process deutliche Vorteile, weil grundsätzlich die Möglichkeit besteht, mit sehr kleinen Zugspannungen der Membranschicht zu arbeiten, da der Strukturierungsprozeß für die Maskenstrukturen auf dem stabilen Wafer und nicht auf der Membran stattfindet. Allerdings entstehen dadurch auch sehr hohe Anforderungen an den Membran-Ätzprozeß.

Gegenstand der Erfindung sind Prozeßfolgen zur Membranätzung im Wafer Flow Prozess, und zwar unter Verwendung von SOI (Silicon On Insulator)- Siliziumscheiben, die für die Herstellung von sogenannten Stencilmasken Anwendung finden. In diesem Zusammenhang sei auf die Veröffentlichung "Highly accurate calibration method of electron-beam cell projection lithography" von Yoshinori Nakayama, Yasunari Sohda, Norio Saitou und Hiroyuki Itoh, in SPIE Vol. 1924 (1993), Seiten 185 und 190, zur SPIE-Tagung 1993 verwiesen. Stencilmasken sind Membranmasken mit geöffneten Strukturen in der Membranschicht.

Aus der eingangs genannten DE 39 00 526 A1 ist ein Verfahren zum Herstellen einer gattungsgemäßen Membran bekannt, bei dem der Ätzstop in herkömmlicher Technik dadurch erreicht wird, daß die verbleibende Membranschicht eine andere, im vorliegenden Fall höhere Dotierung aufweist als die darunterliegende Trägerschicht. Der Abtrag der Trägerschicht erfolgt in zwei getrennten Teilschritten. In einem ersten Ätzschritt wird die Trägerschicht isotrop bis auf eine Restdicke von 10 bis 100 µm abgetragen. Dabei befindet sich der Wafer in einer Ätzdose. In einem zweiten Ätzschritt, der nach Entnahme des Wafers aus der Ätzdose erfolgt, wird die Trägerschicht anisotrop abgetragen, bis die hochbohrdotierte Schicht erreicht ist, die die Membran bildet.

Es ist eine Aufgabe der vorliegenden Erfindung, ein Verfahren der eingangs genannten Art anzugeben, mit dem sich großflächige Membranmasken mit hoher Genauigkeit und Ausbeute herstellen lassen, ohne daß es zu Beschädigungen oder Zerstörungen infolge mechanischer Überanspruchungen kommt.

Diese Aufgabe wird durch ein Verfahren der eingangs genannten Art dadurch gelöst,
- daß als Halbleiterscheibe eine SOI-Siliziumscheibe mit einer ersten Siliziumschicht, einer darunter angeordneten Dielektrikaschicht sowie einer darunter angeordneten zweiten Siliziumschicht verwendet wird,
- daß die erste Siliziumschicht zunächst mit einer Maskenstruktur strukturiert wird,
- daß die zweite Siliziumschicht sodann in einem ersten Ätzschritt bis auf eine Restdicke abgetragen wird, und
- daß die Restdicke der zweiten Siliziumschicht sodann in einem zweiten Ätzschritt abgetragen wird, wobei die Dielektrikaschicht einen Ätzstop bewirkt.

Der Zweischrittprozeß weist Vorteile bei der Wahl der Ätzmedien auf, weil im ersten und zweiten Schritt unterschiedliche Ätzmedien eingesetzt werden können. Bei den zwei Ätzmedien kann es sich um unterschiedliche Ätzmittel oder auch nur um einen Konzentrations- oder Temperaturunterschied desselben Ätzmittels handeln. Da beim SOI Wafer Flow Prozess der Ätzstop an einer Siliziumdioxid-Schicht erfolgt, die aus Gründen der mechanischen Spannungen möglichst dünn sein muß, ist eine hohe Ätzselektivität erforderlich. Deshalb empfiehlt es sich, in diesem Fall den zweiten Ätzschritt mit TMAH durchzuführen, während der erste Schritt in einem KOH-Bad erfolgen kann.

Eine weitere Möglichkeit, die sich aus dem Zweischrittprozeß ergibt, besteht darin, den ersten Schritt als Trockenätzschritt im Plasma durchzuführen.

Eine Schutzbeschichtung kann entsprechend den mechanischen und chemischen Anforderungen vorteilhaft als eine Dielektrikaschicht oder Polymerschicht ausgebildet sein.

Zudem kann die Ätzselektivität des zweiten Schrittes gegenüber der Stopund der Schutzschicht optimiert werden, um die Halbleiterträgerschicht optimal und vollständig zu entfernen, ohne daß Stop- und Schutzschicht zu sehr angegriffen werden.

Der Zweischrittprozeß bietet somit zahlreiche Möglichkeiten der Optimierung hinsichtlich Ätzrate (Produktivität, Kosten) und Selektivität (Ausbeute) des Membran-Ätzprozesses (d.h. Abtrag der Halbleiter-Trägerschicht).

Für das Verfahren bestehen außerdem Möglichkeiten, die Stopschicht selbst hinsichtlich der Anforderungen an ihre mechanischen Eigenschaften zu optimieren sowie den Ätzprozeß an die jeweilige Stopschicht anzupassen. Die Stopschicht kann somit vorteilhaft aus einer Dielektrikaschich oder einer Schichtkombination damit bestehen. Eine ausreichende Selektivität der Stopschicht ist ebenfalls ein wichtiges Optimierungskriterium.

Damit sind vorteilhaft die mechanischen Spannungen im System Membranschicht/Ätzstopschicht/Trägerwafer nicht nur gut beherrschbar, sondern der Zweischrittprozeß läßt eine gezielte Optimierung der mechanischen Spannung der Membranschicht zu.

Das ist von großem Vorteil sowohl für die geometrische Stabilität der Membranmaske als auch die davon abhängige Struktur- und Lagegenauigkeit der Maskenstrukturen.

Die Schicht bzw. Schichtkombination kann auch hinsichtlich einer definierten Leitfähigkeit entsprechend den gewünschten Verwendungen vorteilhaft optimiert werden.

Entsprechend den erfindungsgemäßen Verfahren kann durch entsprechende Anpassung des Abtragens der Halbleiter-Trägerschicht die mechanische Spannung der Membran in weiten Grenzen von Druck- bis Zugspannungen vorteilhaft variiert werden.

Durch Dotierung der Membranschicht auf dem Trägerwafer läßt sich die mechanische Spannung der Membranmaske von Druck- bis Zugspannungen in einem weiten Bereich verändern. Der SOI Wafer Flow Prozess, wie er hier beschrieben wurde, ist dafür besonders geeignet. Die Dielektrikaschicht bewirkt unabhängig vom Dotierungsniveau der darauf befindlichen Siliziumschicht den Ätzstop. Somit kann die Siliziumschicht beliebig, d.h. ausschließlich im Sinne einer optimalen Membranspannung dotiert werden.

Die Verwendung der SOI-Technik hat gegenüber der herkömmlichen elektrochemischen Ätzstoptechnik weitere Vorteile wie, daß das Verfahren einfacher und effektiver wird, sich somit die Ausbeute erhöht und das Verfahren kostengünstiger durchgeführt werden kann.

Die herkömmliche elektrochemische Ätzstoptechnik erlaubt nur ein Verfahren mit einer Ätzzelle, wobei dabei das Ätzen nur in einem Schritt möglich ist. Ebenso werden herkömmlicherweise nur relativ kleine Membranen hergestellt.

Dadurch, daß eine Strukturierung der Maskierungsschicht für die Ätzung der Halbleiter-Trägerschicht als erster Schritt des Verfahrens oder im Rahmen der Herstellung des Halbleiterscheiben-Ausgangsmaterials erfolgt, können dabei auftretende Fehler vorteilhaft nicht zu einem Ausschuß schon kostenintensiver Teile führen. Der Ausschuß betrifft dabei nur relativ kostengünstig vorbearbeitete Teile. Somit werden durch diese vorteilhafte Ausgestaltung des Verfahrens Kosten verringert.

Die Erfindung wird nachstehend ohne Beschränkung des allgemeinen Erfindungsgedankens anhand von Ausführungsbeispielen unter Bezugnahme auf die Zeichnung exemplarisch beschrieben, auf die im übrigen hinsichtlich der Offenbarung aller im Text nicht näher erläuterten erfindungsgemäßen Einzelheiten ausdrücklich verwiesen wird.
- Fig. 1: einen Wafer Flow Prozess unter Verwendung von SOI (Silicon On Insulator)- Siliziumscheiben, wobei die Trägerchicht jedoch in einem Ätzschritt vollständig abgehagen wird,
- Fig. 2: ein erfindungsgemäßes Verfahren zur Herstellung von großflächigen Membranmasken unter Verwendung eines Zweischrittprozesses zur Membranätzung, und
- Fig. 3: ein erfindungsgemäßes Verfahren zur Herstellung von großflächigen Membranmasken unter Verwendung eines Stützgitters zur Membranätzung.

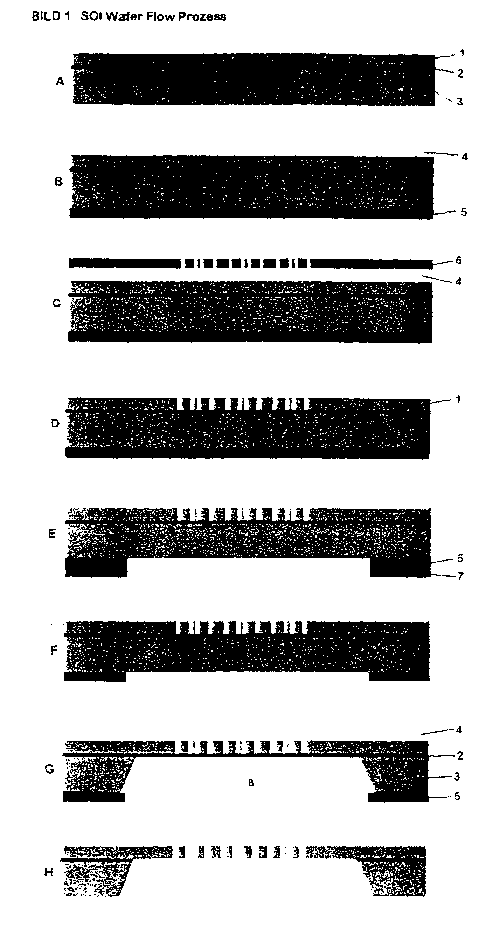

In Fig. 1 sind die wesentlichsten Prozeßschritte eines SOI Wafer Flow Prozesses dargestellt:
1A SOI-Siliziumscheibe als Ausgangsmaterial, wobei die 2-3 µm dicke Siliziumschicht (1) auf der Oberseite die spätere Membranschicht bildet, die durch eine Dielektrikaschicht (2). z.B. Siliziumdioxid 200 bis 400 nm dick, von der 500 bis 600 µm dicken kompakten Siliziumscheibe (3) isoliert ist,
1B Aufbringung einer Maskierschicht (4) auf der Oberseite und einer Maskierschicht (5) auf der Unterseite der Siliziumscheibe,
1C Strukturierung der Maskenstrukturen auf der Oberseite mit Hilfe von Lithografieprozessen zur Herstellung einer Lackmaske (6) und anschließender Plasmaätzung der Maskierschicht (4),
1D Trenchätzung der Maskenstrukturen in die 2-3 µm dicke Siliziumschicht (1) auf der Oberseite und Entfernung der Lackmaske (6),
1E Lithografische Maskierung (7) und Ätzung eines Fensters in die Maskierschicht (5) auf der Unterseite der Siliziumscheibe.
1F Entfernung der Lackmaske (7) für Rückseitenfenster,
1G Membranätzprozess, d.h. Abtrag der kompakten Siliziumscheibe (3) im maskierten Fensterbereich (8),
1H Entfernung der Maskierschichten (4),(5) und der Isolatorschicht (2) im Membranbereich.

Der Membranätzschritt erfolgt im allgemeinen in anisotropen, naßchemischen Ätzprozessen, beispielsweise unter Verwendung einer wässrigen Lösung von KOH oder TMAH (Tetramethyl Ammoniumhydroxide) als Ätzmittel.

Der Ätzstop findet an der Isolatorschicht statt, allerdings nur mit einer begrenzten Selektivität. Da aus Gründen der mechanischen Spannungen die Isolatorschicht möglichst dünn gehalten werden muß und infolge ihrer begrenzten Selektivität, ist der Ätzstop sehr kritisch.

Während des Ätzprozesses, der bei Silizium-Ätzraten von 30-40 µm/h entsprechend viele Stunden dauert, muß außerdem die strukturierte Membranseite absolut sicher vor einem Ätzangriff geschützt sein. Dabei muß sichergestellt werden, daß die zum Schutz der Membranseite eingesetzten Mittel sich am Prozeßende wieder rückstandslos entfernen lassen und sowohl durch das Schutzmittel als auch durch seine Entfernung keine geometrischen Veränderungen an den Strukturen in der Membranschicht auftreten.

Nach dem Stand der Technik existiert eine sehr sichere Methode, um alle Bereiche des Si-Wafers außerhalb des auf der Rückseite geöffneten Fensters abzudichten. nämlich der Einbau in eine Ätzzelle mit Dichtungen, die mechanisch angepresst werden.

Der Nachteil einer solchen Lösung besteht darin, daß die Bruchgefahr am Ende des Ätzprozesses, wenn sich der Membranbereich seiner endgültigen Dicke von wenigen Mikrometern nähert, sehr hoch ist. Hauptursache dafür sind Verspannungen durch die mechanische Abdichtung der Zelle, insbesondere auch deshalb. weil zusätzliche thermische Verspannungen im mindestens 60°C warmen Ätzbad auftreten.

Außerdem läßt es sich nicht vermeiden, daß während der Zellenhandhabung und insbesondere im Ätzbad ein Druckunterschied zwischen dem Zelleninneren und der Außenwelt auftritt, der auf die Membran wirkt und sie leicht zerstören kann.

Schließlich muß die hochempfindliche Membran aus der verhältnismäßig robusten Zelle ausgebaut werden, ein ebenfalls sehr kritische Prozeßschritt.

Ein anderer Weg besteht in der Abdeckung der Membranseite mit einer Schutzschicht, die alle bereits genannten Eigenschaften aufweist wie ausreichende Ätzresistenz und rückstandsfreie Entfernbarkeit bei Nichtbeeinflussung der Membranstrukturen. Außerdem darf auch diese Schicht nur geringe mechanische Spannungen im System Membran/Schutzschicht bewirken, um nicht zur Zerstörung der Membranmaske bereits vor oder während ihrer Entfernung zu führen.

Die Schwierigkeit dieses Weges besteht darin, daß sich bis heute keine Schutzschichten finden lassen, die alle diese Anforderungen gleichzeitig erfüllen.

Da Schutzschichten herstellbar sind, die die speziellen Anforderungen erfüllen, jedoch nur als sehr dünne Schicht und damit mit auch sehr begrenzter Ätzbeständigkeit, kommt erfindungsgemäß ein Zweischrittprozeß für die Membranätzung zur Anwendung.

Zuerst erfolgt die Ätzung in einer Ätzzelle bis zu einer Restdicke, bei der der Membranbereich eine so ausreichende Stabilität aufweist, daß sowohl im Ätzprozeß wie auch bei der Zellen-Handhabung und beim Ausbau der teilgeätzten Membranmaske keine Gefahr der Zerstörung besteht. Die Restätzung erfolgt in einem zweiten Schritt mit einer Schutzschicht auf der Membranseite. Hierfür wird die teilgeätzte Membranmaske in einen einfachen Waferträger eingesetzt und ist damit beim Eintauchen ins Ätzbad keinerlei mechanischen oder thermischen Zwangskräften ausgesetzt. Im ersten Schritt werden etwa 90% und im zweiten Schritt die restliche Schichtdicke bis auf die Membrandicke abgetragen. Als Schutzschichten können sowohl Dielektrikaschichten als auch Polymerschichten Anwendung finden, die entweder auf die strukturierte Maskierschicht oder nach vorheriger Entfernung der Maskierschicht direkt auf die strukturierte Membranschicht aufgebracht werden.

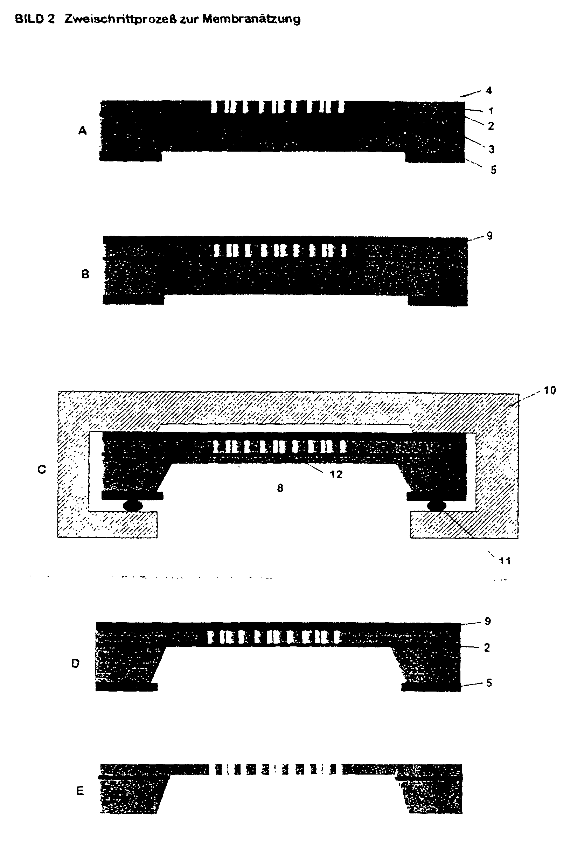

In Fig. 2 sind die wesentlichen Prozeßschritte des Zweischrittprozesses schematisch dargestellt:
2A Startpunkt ist der Prozeßschritt F aus Bild 1. d.h. prozessierter SOI-Wafer mit der strukturierten Membranseite (1)+(4) und dem geöffneten Rückseitenfenster (5) für die Membranätzung,
2B Auf der strukturierten Membranseite wird die für den zweiten Ätzschritt erforderliche Schutzschicht (9) aufgebracht, entweder auf die Maskierschicht (4), oder, wie zeichnerisch dargestellt, nach Entfernung der Maskierschicht auf die Membranschicht (1),
2C Einbau der strukturierten Siliziumscheibe in eine Ätzzelle (10) mit mechanischer Abdichtung (11) und Ätzung des Siliziums im geöffneten Fenster (8) bis auf eine Restdicke (12),
2D. Ausbau der teilgeätzten Siliziumscheibe aus der Ätzzelle und Weiterätzung im Ätzbad bis zur Stopschicht (2),
2E Entfernung von Schutz (9)- und Maskierschicht (5) sowie der Ätzstopschicht (2) im Membranbereich.

Eine anderer Weg. die Bruchgefahr beim Ätzprozeß in einer Ätzzelle zu verringern, besteht erfindungsgemäß darin, die Siliziumschicht nicht sofort großflächig abzutragen, sondern durch entsprechende Maskierung innerhalb des Ätzfensters ein Stützgitter stehen zu lassen, so daß zunächst kleinere Membranflächen entstehen. Der Ausbau der Membranmaske aus der Ätzzelle erfolgt somit noch in einem stabileren Zustand. Erst nach dem Ausbau erfolgt die Entfernung der Ätzstopschicht und gleichzeitig mit ihr auch das Stützgitter, das sich durch Unterätzung abhebt. Da sich mit der Entfernung der Stopschicht auch ihre inneren mechanischen Spannungen abbauen, werden der durch die Stopschicht verursachte Stress und seine durch das Stützgitter teilweise bewirkte Kompensation praktisch simultan beseitigt.

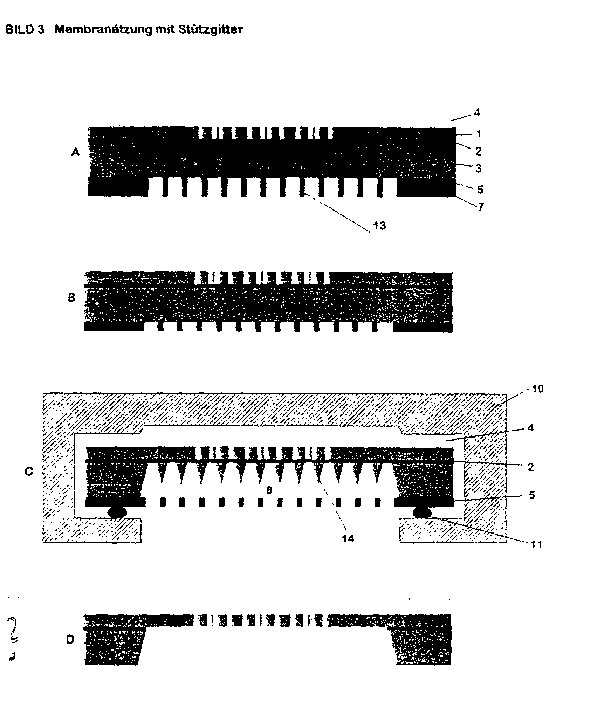

In Fig. 3 sind schematisch die Prozeßschritte mit einem Stützgitter dargestellt:
3A Startpunkt ist der Prozeßschritt E aus Bild 1, wobei die Strukturierung des Rückseitenfensters (5) mit der Lackmaske (7) ergänzt wurde durch die gleichzeitige Strukturierung einer Gittermaskierung (13),
3B Entfernung der Lackmaske (7) für Rückseitenstrukturierung,
3C Einbau der strukturierten Siliziumscheibe in eine Ätzzelle (10) mit mechanischer Abdichtung (11) und Ätzung des Siliziums in den geöffneten Gitterfenstern (8) bis zur Stopschicht,
3D Ausbau der Membranmaske aus der Ätzzelle und Entfernung der Maskierschichten (4)+(5) sowie der Ätzstopschicht (2), wobei sich durch Unterätzung das Stützgitter (14) mit abhebt.

## Patentansprüche

1. Verfahren zur Herstellung von Membranmasken mit Membranflächen bis zu mehr als 100 Quadratzentimeter Größe auf Basis mehrschichtiger Halbleiterscheiben, wobei eine mehrschichtige Halbleiterscheibe in mehreren Teilschritten bis auf eine Membrandicke abgetragen wird, **dadurch gekennzeichnet,**
- **daß** als Halbleiterscheibe eine SOI-Siliziumscheibe mit einer ersten Siliziumschicht (1), einer darunter angeordneten Dielektrikaschicht (2) sowie einer darunter angeordneten zweiten Siliziumschicht (3) verwendet wird,
- **daß** die erste Siliziumschicht (1) zunächst mit einer Maskenstruktur strukturiert wird,
- **daß** die zweite Siliziumschicht (3) sodann in einem ersten Ätzschritt bis auf eine Restdicke (12) abgetragen wird, und
- **daß** die Restdicke (12) der zweiten Siliziumschicht (3) sodann in einem zweiten Ätzschritt abgetragen wird, wobei die Dielektrikaschicht (2) einen Ätzstop bewirkt.

2. Verfahren nach Anspruch 1, **dadurch gekennzeichnet, daß** als Halbleiterscheibe eine SOI-Siliziumscheibe mit einer 2-3µm dicken ersten Siliziumschicht (1) verwendet wird.

3. Verfahren nach Anspruch 1 oder 2, **dadurch gekennzeichnet, daß** der zweite Ätzschritt mit TMAH durchgeführt wird.

4. Verfahren nach einem der Ansprüche 1 bis 3, **dadurch gekennzeichnet, daß** der erste Ätzschritt als Trockenätzschritt im Plasma durchgeführt wird.

5. Verfahren nach einem der Ansprüche 1 bis 3, **dadurch gekennzeichnet, daß** der erste Ätzschritt in einem KOH-Bad erfolgt.

6. Verfahren nach Anspruch 5, **dadurch gekennzeichnet, daß** der Abtrag der zweiten Siliziumschicht (3) in einer mechanisch gedichteten Ätzzelle (10) zunächst mit einem Stützgitter (14) erfolgt und das Stützgitter (14) erst nach dem Ausbau aus der Ätzzelle (10) entfernt wird.

7. Verfahren nach Anspruch 6, **dadurch gekennzeichnet, daß** das Stützgitter (14) durch Unterätzung zusammen mit der Dielektrikaschicht (2) entfernt wird.

8. Verfahren nach einem der Ansprüche 1 bis 7, **dadurch gekennzeichnet, daß** im ersten Ätzschritt etwa 90% der zweiten Siliziumschicht (3) abgetragen wird.

9. Verfahren nach einem der Ansprüche 1 bis 8, **dadurch gekennzeichnet, daß** die erste Siliziumschicht (1) im Sinne einer optimalen Membranspannung dotiert wird.

## Claims

1. Method of producing large-area membrane masks having a membrane area up to sizes of more than 100 square centimeters on the basis of multi-layer semiconductor wafers, wherein a multi-layer semiconductor wafer is stripped in several partial steps up to a membrane thickness, **characterized in**
- **that** a SOI silicon wafer having a first silicon layer (1), a dielectric layer (2) arranged underneath, and a second silicon layer (3) arranged underneath is used,
- **that** the first silicon layer (1) is initially structured with a mask structure,
- **that** the second silicon layer (3) is then stripped in a first etching step up to a residual thickness (12), and
- **that** the residual thickness (12) of the second silicon layer (3) is then stripped in a second etching step, wherein the dielectric layer (2) causes an etching stop.

2. Process according to claim 1, **characterized in that** a SOI silicon layer having a first silicon layer (1) with a thickness of 2-3 µm is used.

3. Process according to claim 1 or 2, **characterized in that** the second etching step is carried out with TMAH.

4. Process according to any of claims 1 to 3, **characterized in that** the first etching step is carried out as a dry etching step in plasma.

5. Process according to any of claims 1 to 3, **characterized in that** the first etching step is achieved in a KOH bath.

6. Process according to claim 5, **characterized in that** the stripping of the second silicon layer (3) is carried out in a mechanically sealed etching cell (10) initially with a supporting grid (14), and the supporting grid (14) is removed only after withdrawal from the etching cell (10).

7. Process according to claim 6, **characterized in that** the supporting grid (14) is removed together with the dielectric layer (2) by etching underneath.

8. Process according to any of claims 1 to 7, **characterized in that** about 90 % of the second silicon layer (3) is stripped in the first etching step.

9. Process according to any of claims 1 to 8, **characterized in that** the first silicon layer (1) is doped in terms of an optimum membrane tension.

## Revendications

1. Procédé de préparation de masques membranaires avec une surface de membrane de jusqu'à plus de 100 centimètres carrés, à base de pastilles de semi-conducteur multicouches, dans lequel une pastille de semi-conducteur multicouche est dégradée en plusieurs étapes jusqu'à une épaisseur de membrane, **caractérisé en ce que** :
- l'on utilise comme pastille de semi-conducteur, une pastille de silicium-SOI avec une première couche de silicium (1), une couche diélectrique (2) disposée dessous, ainsi qu'une deuxième couche de silicium (3) disposée dessous;
- l'on structure d'abord la première couche de silicium (1), avec une structure de masque ;
- l'on dégrade ensuite la deuxième couche de silicium (3) au cours d'une première étape de gravure jusqu'à une épaisseur résiduelle (12), et
- l'on dégrade ensuite l'épaisseur résiduelle (12) de la deuxième couche de silicium (3), au cours d'une deuxième étape de gravure, dans laquelle la couche diélectrique (2) effectue un arrêt de gravure.

2. Procédé selon la revendication 1, **caractérisé en ce que** l'on utilise comme pastille de semi-conducteur, une pastille de silicium-SOI avec une première couche de silicium (1) ayant une épaisseur de 2-3 µm.

3. Procédé selon la revendication 1 ou 2, **caractérisé en ce que** l'on réalise la deuxième étape de gravure avec du TMAH.

4. Procédé selon l'une des revendications 1 à 3, **caractérisé en ce que** la première étape de gravure est réalisée comme une étape de gravure à sec dans un plasma.

5. Procédé selon l'une des revendications 1 à 3, **caractérisé en ce que** la première étape de gravure est réalisée dans un bain de KOH.

6. Procédé selon la revendication 5, **caractérisé en ce que** l'enlèvement de la deuxième couche de silicium (3) est réalisé dans une cellule de gravure rendue mécaniquement étanche (10), d'abord avec une grille support (14), et la grille support (14) est enlevée seulement après le démontage hors de la cellule de gravure (10).

7. Procédé selon la revendication 6, **caractérisé en ce que** la grille support (14) est enlevée par sous-gravure avec la couche diélectrique (2).

8. Procédé selon l'une des revendications 1 à 7, **caractérisé en ce que** dans la première étape de gravure, on dégrade environ 90% de la deuxième couche de silicium (3).

9. Procédé selon l'une des revendications 1 à 8, **caractérisé en ce que** la première couche de silicium (1) est dopée dans le sens d'une tension optimale de la membrane.
